# EUROPEAN PATENT APPLICATION

(11) **EP 4 806 831 A1**
(43) Date of publication of application: **16.09.2026**
(21) Application number: 24902585.9
(22) Date of filing: 29.11.2024
(51) Int. Cl.: B66F 7/00, B66F 7/28, B65G 15/58, B65G 15/30, H01L 21/677, F27D 3/00

(54) **VERTICAL HEAT TREATMENT APPARATUS AND CONVEYING DEVICE THEREFOR**

(30) Priority: 15.12.2023 CN 202311734541
(71) Applicant: Beijing NAURA Microelectronics Equipment Co., Ltd., Beijing 100176 (CN)
(72) Inventor: LIU, Hongliang, Beijing 100176 (CN); HUANG, Mintao, Beijing 100176 (CN); WANG, Lika, Beijing 100176 (CN); MA, Yongchang, Beijing 100176 (CN)
(74) Representative: Cohausz & Florack
(86) International application number: PCT/CN2024/135507
(87) International publication number: WO 2025/124163

(57) **Abstract**

There are provided a vertical heat treatment apparatus and a conveying device therefor. The conveying device includes a main body, a transmission belt mechanism (400), and a stop mechanism (500), and the transmission belt mechanism (400) is used for transmission between a driving part and a driven part of the main body, and includes a transmission belt (401); the stop mechanism (500) includes a stop portion and an engagement assembly, the stop portion is fixedly connected to the driven part, and the engagement assembly includes a stop member, and abuts against the transmission belt (401) to disengage the stop member from the stop portion; when the transmission belt (401) breaks, the engagement assembly disengages from the transmission belt (401), and the stop member is in limit fit with the stop portion to stop the driven part from rotating. A stopping process of the conveying device does not need a detection device for signal detection, and does not need signal control for achieving stopping, so that reliability of the stopping process is improved, and cost of the conveying device is reduced.

## Description

### TECHNICAL FIELD

The present disclosure relates to the field of semiconductor manufacturing, and in particular, to a vertical heat treatment apparatus and a conveying device therefor.

### BACKGROUND

A boat lifting system for a vertical furnace is configured to convey a quartz boat loaded with silicon wafers into a reaction furnace tube for a related process, and convey the silicon wafers and the quartz boat out of the reaction furnace tube after the process is completed. Z-axis transmission of the boat lifting system is mainly implemented by a guide rail, a ball screw, and a motor drive mechanism, and the motor drive mechanism is connected to the ball screw through a timing belt for transmitting torque. When the timing belt breaks, the connection between the ball screw and the motor drive mechanism is interrupted. Since the ball screw does not have a self-locking function, the silicon wafers and the quartz boat conveyed by the boat lifting system fall under the action of gravity after the connection with the motor drive mechanism is interrupted, such that the silicon wafers and the quartz boat are damaged, resulting in a serious production accident.

Therefore, how to improve reliability during a stopping process is an urgent technical problem to be solved by those of ordinary skill in the art.

### SUMMARY

The present disclosure aims to solve at least one technical problem in the existing art, and proposes a vertical heat treatment apparatus and a conveying device therefor, which adopt a mechanical mechanism to stop rotation of a driven part when a transmission belt breaks, thereby improving reliability of a stopping process and reducing equipment cost.

In order to achieve the objective of the present disclosure, there is provided a conveying device for a vertical heat treatment apparatus, including a main body, a transmission belt mechanism, and a stop mechanism, wherein
the transmission belt mechanism is used for transmission between a driving part and a driven part of the main body, and includes a transmission belt;
the stop mechanism includes a stop portion and an engagement assembly, the stop portion is fixedly connected to the driven part, and the engagement assembly includes a stop member, and abuts against the transmission belt to disengage the stop member from the stop portion; when the transmission belt breaks, the stop member is in limit fit with the stop portion to stop the driven part from rotating.

In some embodiments, the engagement assembly further includes a tensioning assembly, the tensioning assembly abuts against the transmission belt to tension the transmission belt, and by abutting against the transmission belt, the tensioning assembly enables the stop member to disengage from the stop portion.

In some embodiments, the tensioning assembly includes a connecting plate, a tension pulley, and an elastic member, wherein
the connecting plate is rotatably connected to the main body; and the tension pulley is rotatably connected to the connecting plate; and
the elastic member is connected to the main body and the connecting plate, and is configured to drive the tension pulley through the connecting plate to abut against the transmission belt and to locate the connecting plate between the stop member and the stop portion for blocking; and the elastic member is further configured to drive the connecting plate away from a position between the stop member and the stop portion when the transmission belt breaks to bring the stop member into limit fit with the stop portion.

In some embodiments, the tensioning assembly further includes a mounting shaft, the connecting plate is rotatably connected to the main body through the mounting shaft, the tension pulley is located at one end of the connecting plate, and the other end of the connecting plate is configured to be located between the stop member and the stop portion for blocking.

In some embodiments, the stop portion is provided with a stop structure for limit fit with the stop member, the number of stop structures is more than one, the stop structures are evenly distributed along a preset circumference, and a center of the preset circumference is located on an axis of the driven part.

In some embodiments, the main body is connected to a mounting base, the stop member is a stop pin, the stop structure is a stop hole, and the mounting base is elastically connected to the stop pin to insert the stop pin into the stop hole under an elastic force.

In some embodiments, the transmission belt mechanism further includes a driven pulley, and the stop portion is disposed between the driven pulley and the main body.

In some embodiments, the main body further includes a lifting portion and a frame, the driven part is a lead screw, the lead screw is vertically disposed, the lifting portion is in thread fit with the lead screw, the frame is configured to limit rotation of the lifting portion, and the lifting portion is configured to support a carrier boat and drive the carrier boat to ascend and descend.

In some embodiments, the mounting base is provided with a mounting hole, the mounting hole is provided therein with a mounting cylinder, the stop member is partially inserted into the mounting cylinder, and is in clearance fit with the mounting cylinder, and an elastic support is disposed between a bottom of the mounting cylinder and the stop member.

In some embodiments, an end of the stop member away from the mounting cylinder is provided with a guide head, and a diameter of the guide head gradually decreases in a direction away from the mounting cylinder.

The present disclosure further provides a vertical heat treatment apparatus, including an apparatus main body and the above conveying device, and
the conveying device includes the driven part and a lifting portion in driving engagement with the driven part, the driven part is configured to drive the lifting portion to ascend to transfer wafers into the apparatus main body or to descend to transfer the wafers out of the apparatus main body, the stop member is used for limit fit with the stop portion when the transmission belt breaks to limit rotation of the driven part, so as to prevent the lifting portion from falling.

The present disclosure has the following beneficial effects.

The conveying device for a vertical heat treatment apparatus provided in the present disclosure includes the main body, the transmission belt mechanism, and the stop mechanism, the transmission belt mechanism used for transmission between the driving part and the driven part of the main body, and includes the transmission belt; the stop mechanism includes the stop portion and the engagement assembly, the stop portion is fixedly connected to the driven part, and the stop portion is provided with the stop structure; and the engagement assembly includes the stop member, the stop member of the engagement assembly is moved away from the stop structure under the support from the transmission belt, and the stop member cooperates with the stop structure to stop the driven part from rotating when the transmission belt breaks.

In the conveying device, the engagement assembly is supported by the transmission belt, so that the stop member is kept away from the stop structure; and whether the transmission belt breaks is determined based on a supporting force. After the transmission belt breaks, the supporting force disappears, and the stop member moves towards the stop structure and cooperates with the stop structure to prevent the driven part from rotating. A stopping process of the conveying device does not need a detection device for signal detection, and does not need signal control for achieving stopping, so that reliability of the stopping process is improved, and cost of the conveying device is reduced.

The present disclosure further provides the vertical heat treatment device, which includes the above conveying device and has the above advantages.

### BRIEF DESCRIPTION OF DRAWINGS

The drawings for the description of the embodiments or the related technology will be briefly described below. Apparently, the drawings described below are just for some embodiments of the present disclosure, and other drawings can be derived by those of ordinary skill in the art from the drawings described below without any inventive work.
FIG. 1 illustrates a conveying device according to an implementation of the present disclosure;
FIG. 2 is a bottom view of a transmission belt of the conveying device of FIG. 1 when the transmission belt does not break;
FIG. 3 is a schematic structural diagram of the transmission belt of the conveying device of FIG. 1 when the transmission belt does not break;
FIG. 4 is an enlarged view of a portion A of FIG. 3;
FIG. 5 is a bottom view of the transmission belt of the conveying device of FIG. 1 when the transmission belt breaks;
FIG. 6 is a schematic structural diagram of the transmission belt of the conveying device of FIG. 1 when the transmission belt breaks;
FIG. 7 is an enlarged view of a portion B of FIG. 6;
FIG. 8 is a schematic structural diagram of a tensioning assembly of FIG. 2;
FIG. 9 is a schematic structural diagram of a stop plate and a driven pulley; and
FIG. 10 is a schematic structural diagram of a vertical heat treatment apparatus according to an implementation.

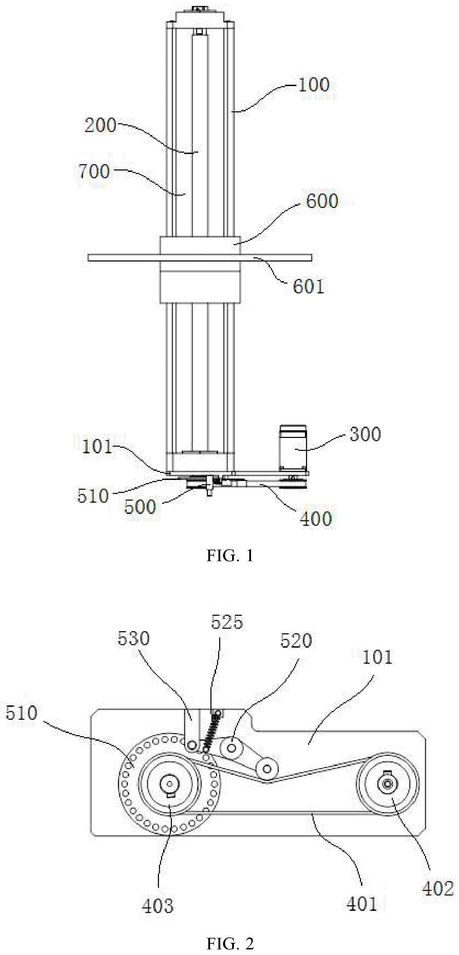

The reference numerals in FIG. 1 to FIG. 10 are as follows:
100-frame; 101-mounting plate; 200-lead screw; 300-drive motor; 400-transmission belt mechanism; 401-transmission belt; 402-driving pulley; 403-driven pulley; 500-stop mechanism; 510-stop plate; 511-stop hole; 520-tensioning assembly; 521-connecting plate; 522-tension pulley; 523-mounting shaft; 524-connecting portion; 525-tension spring; 530-stop assembly; 531-mounting base; 532-mounting cylinder; 533-stop pin; 600-lifting portion; 601-support plate; 700-guide rail; 800-carrier boat; 900-vertical reaction furnace.

### DETAIL DESCRIPTION OF EMBODIMENTS

In order to enable those of ordinary skill in the art to better understand the technical solutions of the present disclosure, a vertical heat treatment apparatus and a conveying device therefor provided in the present disclosure are described in detail below with reference to the drawings.

In the related technology, whether the timing belt breaks may be detected with a photoelectric switch, and if the timing belt breaks, a brake is controlled to clamp the ball screw tightly, so as to prevent the silicon wafers and the quartz boat from falling. However, if the photoelectric switch is abnormal during detection, failure in an anti-drop function or misjudgment may be caused, which affects reliability of the apparatus.

As shown in FIG. 1, a conveying device for a vertical heat treatment apparatus provided in the present disclosure includes a main body, a transmission belt mechanism 400, and a stop mechanism 500. The main body includes a driving part and a driven part, and the driving part is in transmission connection with the driven part through the transmission belt mechanism 400 to drive the driven part to rotate. As shown in FIG. 2, the transmission belt mechanism 400 includes a transmission belt 401, a driving pulley 402, and a driven pulley 403, the driving pulley 402 is connected to the driving part, the driven pulley 403 is connected to the driven part, and the transmission belt 401 surrounds the driving pulley 402 and the driven pulley 403, rotates along with the driving pulley 402, and drives the driven pulley 403 to rotate, thereby realizing power transmission from the driving part to the driven part. During the power transmission, the transmission belt 401 is always kept in a tensioned state, and thus has a certain tension which enables the transmission belt 401 to support other components. If the transmission belt 401 breaks, the transmission belt 401 loses the capability to support the other components. Illustratively, the driving part may be a drive motor 300, and the driven part may be a lead screw 200. Certainly, the driving part and the driven part may be other structures, which is not limited herein.

The stop mechanism 500 includes a stop portion and an engagement assembly. The stop portion is fixedly connected to the lead screw 200, and rotates along with the lead screw 200. The engagement assembly includes a stop member. The engagement assembly abuts against the transmission belt 401; and under the support from the transmission belt 401, the stop member disengages from the stop portion. If the transmission belt 401 breaks, the supporting force disappears, the stop member moves towards the stop portion and finally comes into limit fit with the stop portion to stop the stop portion from rotating, thereby stopping the lead screw 200 from rotating.

It should be noted that the stop portion is provided with a stop structure for the limit fit with the stop member; under the support from the transmission belt 401, that is, when the transmission belt 401 does not break, the stop member is kept away from the stop structure, so that the stop member disengages from the stop portion. When the transmission belt 401 breaks, the stop member moves towards the stop structure and comes into limit fit with the stop structure to stop the stop portion from rotating, thereby stopping the lead screw 200 from rotating.

In the conveying device provided in the present embodiment, the engagement assembly is supported by the transmission belt 401, so that the stop member of the engagement assembly is kept away from the stop structure. After the transmission belt 401 breaks, the stop member moves towards the stop structure and comes into limit fit with the stop structure, thereby stopping the lead screw 200 from rotating. That is, in the conveying device provided in the present embodiment, a mechanical structure is adopted to stop the lead screw 200 after the transmission belt 401 breaks, so that there is no need to provide a photoelectric switch, which reduces equipment cost; moreover, there is no need to control the stopping process by detection of signals, which avoids misjudgment or stop failure caused by signal abnormality, thereby improving reliability of the conveying device.

In some embodiments, the transmission belt 401 may be a timing belt. An inner peripheral wall of the timing belt, an outer circumferential wall of the driving pulley 402, and an outer circumferential wall of the driven pulley 403 are all provided with transmission teeth, the timing belt engages with the driving pulley 402 through the transmission teeth, and also engages with the driven pulley 403 through the transmission teeth, so as to be prevented from sliding relative to the driving pulley 402 and the driven pulley 403 during a transmission process, thereby improving transmission efficiency of the timing belt mechanism.

In some embodiments, the engagement assembly further includes a tensioning assembly 520. The tensioning assembly 520 is connected to the main body for abutting against the transmission belt 401 to tension the transmission belt 401; meanwhile, the transmission belt 401 supports the tensioning assembly 520. Supported by the transmission belt 401, the tensioning assembly 520 keeps the stop member away from the stop structure.

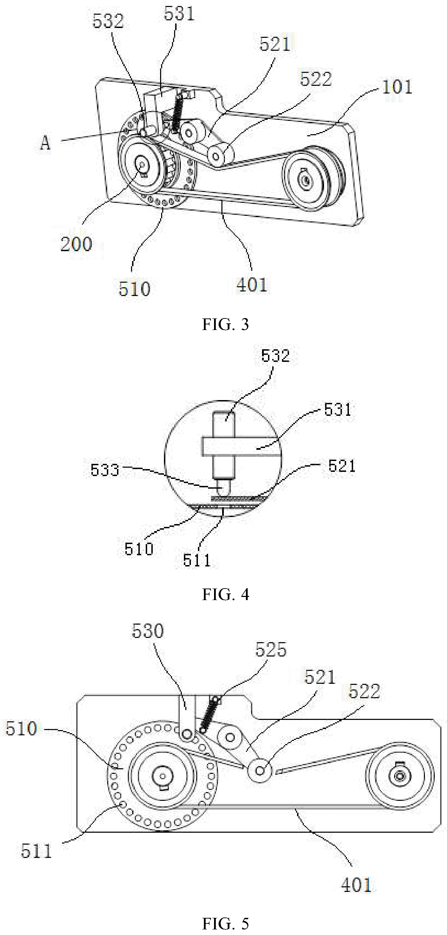

In some embodiments, as shown in FIG. 4, the stop member may be a stop pin 533, and the stop structure may be a stop hole 511 formed in the stop portion. The main body further includes a frame 100. The stop pin 533 is movably connected to the frame 100, and is capable of being inserted into the stop hole 511 to be in limit fit with the stop portion when the transmission belt 401 breaks, so as to stop the lead screw 200 from rotating. The tensioning assembly 520 is configured to prevent the stop pin 533 from being inserted into stop hole 511 when the transmission belt 401 does not break. Certainly, the stop structure may be other structures such as stop teeth, the engagement assembly may be inserted into a gap between the stop teeth and abut against the stop teeth to stop the lead screw 200, and reference may be made to a ratchet pulley for specific configuration. By achieving stopping through cooperation of the stop pin 533 and the stop hole 511, high stop reliability can be realized. A structure around the stop hole 511 has high structural strength, so that the stopping can be achieved once the stop pin 533 is inserted the stop hole 511, with no risk of tooth breakage or tooth disengagement

In some embodiments, as shown in FIG. 2, the engagement assembly further includes a stop assembly 530. As shown in FIG. 4, the stop assembly 530 includes an elastic support (not shown) and the stop pin 533, and the elastic support is configured to provide elastic thrust for the stop pin 533. As shown in FIG. 5 to FIG. 7, when the transmission belt 401 breaks, the stop pin 533 may be pushed by the elastic thrust provided by the elastic support to be inserted into the stop hole 511, thereby stopping the lead screw 200 from rotating. In the stop assembly 530, by pushing the stop pin 533 with the elastic support, the risk of jamming of the stop pin 533 can be reduced, and the success rate of the stop pin 533 being inserted into the stop hole 511 can be increased, so that reliability of the stopping process is improved. However, the present disclosure is not limited thereto. In some other embodiments not illustrated by the drawings, the stop portion may be located below the stop pin 533, and the stop pin 533 may be inserted into the stop hole 511 under gravity. In this case, the stop pin 533 only needs to be mounted to the frame 100.

As shown in FIG. 2 to FIG. 4, the tensioning assembly 520 may tension the transmission belt 401; meanwhile, the transmission belt 401 provides a supporting force for the tensioning assembly 520 to insert part of the tensioning assembly 520 between the stop pin 533 and the stop portion, thereby preventing the stop pin 533 from being inserted into the stop hole 511. As shown in FIG. 5 to FIG. 7, after the transmission belt 401 breaks, the supporting force disappears, a position of the tensioning assembly 520 is changed, and the tensioning assembly 520 moves away from the position between the stop pin 533 and the stop portion, which allows the stop pin 533 to be inserted into the stop hole 511, thereby completing the stopping process.

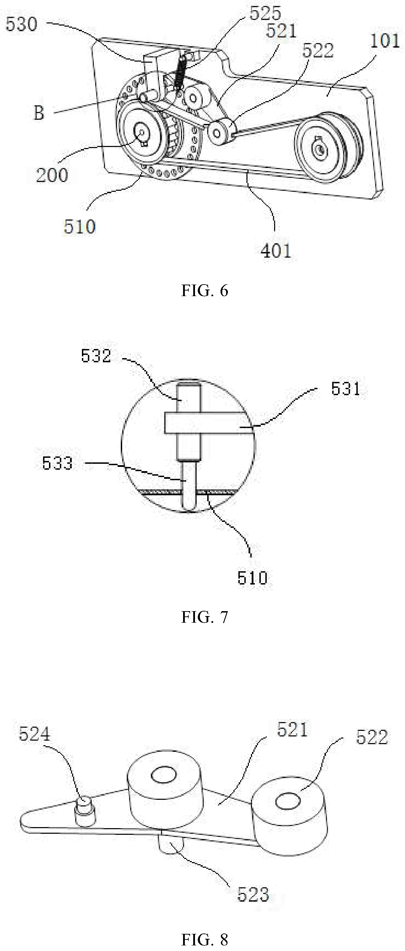

In some embodiments, as shown in FIG. 2 and FIG. 8, the tensioning assembly 520 includes a mounting shaft 523, a connecting plate 521, a tension pulley 522, and an elastic member. As shown in FIG. 8, the connecting plate 521 is provided with a connecting portion 524, a connecting hole (not shown), and a rotation shaft. The mounting shaft 523 is fixedly connected to the frame 100, and the mounting shaft 523 is inserted into the connecting hole to rotatably connect the connecting plate 521 to the frame 100. The tension pulley 522 is rotatably connected to the connecting plate 521 through the rotation shaft. The frame 100 is provided with a connecting base, one end of the elastic member is connected to the connecting base, and the other end of the elastic member is connected to the connecting portion 524, thereby achieving elastic connection between the frame 100 and the connecting plate 521. In an implementation illustrated by FIG. 2, the elastic member is a tension spring 525, but the present disclosure is not limited thereto. In some other embodiments not illustrated by the drawings, other structures such as a rubber belt may be selected as the elastic member as needed, which is not limited herein.

When the tension spring 525 elastically deforms, the tension spring 525 applies a first torque to the connecting plate 521 to rotate the connecting plate 521 around the mounting shaft 523, thereby attaching the tension pulley 522 to the transmission belt 401 and tensioning the transmission belt 401 as shown in FIG. 2 and FIG. 3. The transmission belt 401 applies a second torque to the connecting plate 521 via the tension pulley 522, and the second torque and the first torque are opposite in direction and are balanced. At this time, the connecting plate 521 is partially located between the stop pin 533 and the stop portion, and thus can block the stop pin 533. When the transmission belt 401 breaks, the second torque disappears, and the connecting plate 521 is moved away from the position between the stop pin 533 and the stop portion under the first torque.

In some embodiments, the tension pulley 522 is located at one end of the connecting plate 521, the other end of the connecting plate 521 is configured to be located between the stop member and the stop portion for blocking, and the mounting shaft 523 is located between the two ends of the connecting plate. Illustratively, the mounting shaft 523 is connected to a middle portion of the connecting plate 521, the tension pulley 522 is located at one end of the connecting plate 521, and an end of the connecting plate 521 away from the tension pulley 522 extends between the stop pin 533 and the stop portion. As shown in FIG. 8, the connecting plate 521 is in a strip shape, and the tension pulley 522 and a portion extending between the stop pin 533 and the stop portion are respectively located at two ends of the connecting plate 521, which can avoid mutual interference of the transmission belt 401 and the stop pin 533, and improve flexibility of arrangement of the components. Moreover, with such configuration, a desired size of the connecting plate 521 can be reduced, a volume of the space occupied by the conveying device can also be reduced. Certainly, the present disclosure is not limited thereto. In some other embodiments not illustrated by the drawings, positions of the tension pulley 522, the stop pin 533, and the mounting shaft 523 may be arranged in other ways, for example, the mounting shaft 523 may be connected to one end of the connecting plate 521 and the middle portion of the connecting plate 521 is configured to block the stop pin 533, which is not limited herein.

In some embodiments, as shown in FIG. 3 and FIG. 4, the stop assembly 530 further includes a mounting base 531. The mounting base 531 is connected to the frame 100 for installation of the stop pin 533 and the elastic support. As shown in FIG. 2 and FIG. 3, the mounting base 531 may be L-shaped, one side of the mounting base 531 is used as a connecting arm to connect the frame 100, and the other side of the mounting base 531 is used as a suspension arm to be suspended on a side of the stop portion away from the frame 100. The stop pin 533 is connected to the suspension arm, and is opposite to a position of the stop hole 511 in the stop portion. The elastic support is located on a side of the stop pin 533 away from the stop portion, and provides elastic thrust for the stop pin 533 to enable the stop pin 533 to be inserted into the stop hole 511. The elastic support may be a support spring, a rubber block, a silicon block, or the like. A structure of the mounting base 531 may be configured as needed, and is not limited herein. In some embodiments, the mounting base 531 is provided with a mounting hole. The mounting hole may be in the suspension arm of the mounting base 531 and opposite to the position of the stop hole 511. The mounting hole is provided therein with a mounting cylinder 532, and the stop pin 533 is partially inserted into the mounting cylinder 532, and is in clearance fit with the mounting cylinder 532. The elastic support is located between a bottom of the mounting cylinder 532 and the stop pin 533, and applies elastic thrust to the stop pin 533 towards the stop portion to enable the stop pin 533 to be inserted into the stop hole 511. In the stop assembly 530, with the stop pin 533 pushed into the stop hole 511 with the elastic support, the thrust is larger than gravity, and is not limited by relative positions of the stop pin 533 and the stop portion, so that flexibility of setting of a position of the stop pin 533 is improved, the risk of stop failure is reduced, and the reliability of the apparatus is improved.

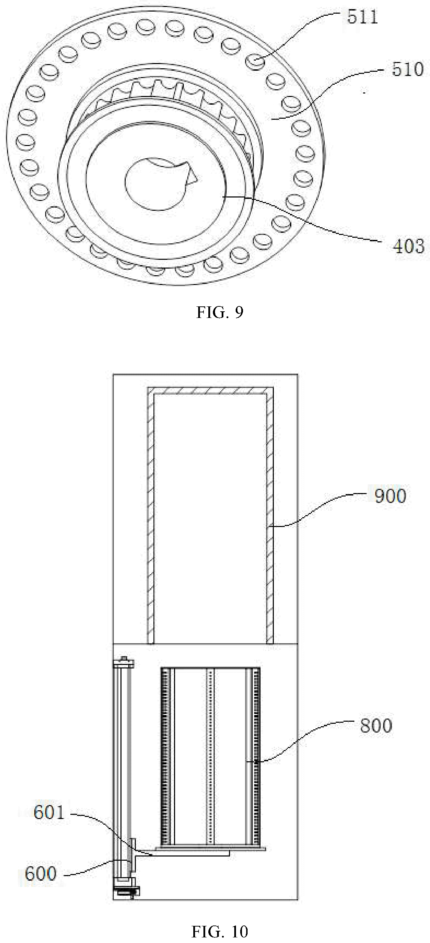

In some embodiments, the number of stop holes 511 is more than one, and a plurality of stop holes 511 are evenly distributed along a preset circumference, a center of which is located on an axis of the lead screw 200. As shown in FIG. 5 and FIG. 9, the stopping can be achieved by inserting the stop pin 533 into any one of the stop holes 511. During normal operation, the stop holes 511 rotate around the axis of the lead screw 200 while the position of the stop pin 533 is fixed. During the stopping process, a stopping operation cannot be completed until the stop hole 511 rotates to a position corresponding to that of the stop pin 533. The greater the distance between the stop hole 511 and the stop pin 533, the longer the lagging time of the stopping process. Therefore, increasing the number of stop holes 511 can effectively shorten an average lagging time and improve stopping efficiency. Certainly, the number of stop holes 511 cannot be increased without limitation, and the structural strength of the structure around the stop hole 511 and structural strength of the stop pin 533 need to be ensured for preventing the stop portion or the stop pin 533 from being damaged to cause the stop failure.

In some embodiments, the stop hole 511 may be arranged near an edge of the stop portion to increase a distance between the stop hole 511 and the axis of the lead screw 200. After the transmission belt 401 breaks, the lead screw 200 rotates under the inertia effect, and an inertia torque of the lead screw 200 may be approximately a fixed value; as the distance between the stop hole 511 and the axis of the lead screw 200 becomes greater, a force desired for stopping becomes smaller, which may reduce requirements on structural strength of the stop portion and that of the stop pin 533.

In some embodiments, the stop portion is disposed between the driven pulley 403 and the frame 100. As shown in FIG. 3 and FIG. 9, the stop portion may be a disk-shaped stop plate 510, and is disposed coaxially with the driven pulley 403, a diameter of the stop plate 510 is greater than that of the driven pulley 403, and the stop holes 511 are distributed at an edge of the stop plate 510. By disposing the stop plate 510 between the driven pulley 403 and the frame 100, the space occupied by the stop plate can be reduced, thereby reducing a volume of the conveying device. Certainly, a position of the stop plate 510 may be set by a user as needed, which is not limited herein.

In some embodiments, the stop plate 510 and the driven pulley 403 may be an integral structure. With the stop plate 510 and the driven pulley 403 being the integral structure, structural strength can be improved; moreover, the stop plate 510 and the driven pulley 403 can share one connecting member, so that the number of installation steps is reduced, and installation efficiency is improved. Certainly, the stop plate 510 and the driven pulley 403 may be configured as split structures by the user, which is not limited herein.

In some embodiments, an end of the stop pin 533 away from the mounting cylinder 532 is provided with a guide head, and a diameter of the guide head gradually decreases in a direction away from the mounting cylinder 532. As shown in FIG. 7, the guide head is hemispherical, and can reduce the difficulty in inserting the stop pin 533 into the stop hole 511, so that the stop pin 533 can be inserted into the stop hole 511 even if the stop hole 511 deviates from the stop pin 533, which reduces possibility of the stop failure, enables the stop pin 533 to be inserted into the stop hole 511 quickly, and improves stopping efficiency. In addition, the hemispherical guide head has high structural strength, so that the risk of damage to the guide head during the stopping process can be reduced. Certainly, the guide head of other structures such as a conical guide head may be selected as needed, which is not limited herein.

In some embodiments, as shown in FIG. 10, the conveying device drives a carrier boat 800 to ascend into a vertical reaction furnace 900, or drives the carrier boat 800 to descend out of the vertical reaction furnace 900. Therefore, the lead screw 200 is disposed vertically. The main body further includes a lifting portion 600 in thread fit with the lead screw 200, the frame 100 is configured to limit rotation of the lifting portion 600, and the lifting portion 600 is configured to support the carrier boat 800 and drive the carrier boat 800 to ascend and descend. As shown in FIG. 10, the lifting portion 600 is provided with a support plate 601, and the carrier boat 800 may be placed on the support plate 601. As shown in FIG. 1, the driving part may be the drive motor 300, and the drive motor 300 drives the lead screw 200 through the transmission belt mechanism 400 to rotate, so as to drive the lifting portion 600 to move up and down for conveying of the carrier boat 800. The frame 100 of the conveying device is provided with a guide rail 700 disposed in parallel with the lead screw 200, the lifting portion 600 is provided with a guide hole, the guide rail 700 extends in the guide hole and is in clearance fit with the guide hole, the guide rail 700 plays a limiting role during movement of the lifting portion 600 to prevent the lifting portion 600 from rotating. Certainly, in some other embodiments, the rotation of the lifting portion 600 may be limited in other ways, which is not limited herein.

In some embodiments, a lower portion of the frame 100 is provided with a mounting plate 101, and the driving part, the transmission belt mechanism 400, and the stop mechanism 500 are all disposed at the mounting plate 101. As shown in FIG. 1, the drive motor 300 is disposed on an upper surface of the mounting plate 101, and the transmission belt mechanism 400 and the stop mechanism 500 are disposed on the lower surface of the mounting plate 101, With such configuration, a height of each component is reduced, and maintenance and use of each component are facilitated. Further, all the components are arranged in a centralized manner, which can further reduce difficulty in maintenance and use. Certainly, a position of each component may be set by the user as needed, which is not limited herein.

The present disclosure further provides a vertical heat treatment apparatus, including an apparatus main body and the conveying device provided in any one of the above embodiments. The conveying device includes the driven part and the lifting portion in driving engagement with the driven part, the driven part is configured to drive the lifting portion to ascend to transfer wafers into the apparatus main body or to descend to transfer the wafers out of the apparatus main body, the stop member is used for limit fit with the stop portion when the transmission belt breaks to limit the rotation of the driven part, so as to prevent the lifting portion from falling under the action of gravity, thereby preventing the wafers from being damaged due to the falling, and improving safety and reliability of the vertical heat treatment apparatus.

In some embodiments, in an implementation illustrated by FIG. 10, the apparatus main body is the vertical reaction furnace 900, and the conveying device is located below the vertical reaction furnace 900 for transferring the wafers into the vertical reaction furnace 900 or transferring the wafers out of the vertical reaction furnace 900. Certainly, the apparatus main body is not limited to the vertical reaction furnace 900.

It should be understood that the above implementations are just exemplary implementations adopted to illustrate the principle of the present disclosure, and the present disclosure is not limited thereto. Various modifications and improvements can be made by those of ordinary sill in the art without departing from the spirit and essence of the present disclosure, and those modifications and improvements are also considered to fall within the scope of the present disclosure.

## Claims

1. A conveying device for a vertical heat treatment apparatus, comprising a main body, a transmission belt mechanism, and a stop mechanism, wherein
the transmission belt mechanism is used for transmission between a driving part and a driven part of the main body, and comprises a transmission belt;
the stop mechanism comprises a stop portion and an engagement assembly, the stop portion is fixedly connected to the driven part, and the engagement assembly comprises a stop member, and abuts against the transmission belt to disengage the stop member from the stop portion; when the transmission belt breaks, the engagement assembly disengages from the transmission belt, and the stop member is in limit fit with the stop portion to stop the driven part from rotating.

2. The conveying device of claim 1, wherein the engagement assembly further comprises a tensioning assembly, wherein
the tensioning assembly abuts against the transmission belt to tension the transmission belt, and by abutting against the transmission belt, the tensioning assembly enables the stop member to disengage from the stop portion.

3. The conveying device of claim 2, wherein the tensioning assembly comprises a connecting plate, a tension pulley, and an elastic member, wherein
the connecting plate is rotatably connected to the main body; and the tension pulley is rotatably connected to the connecting plate; and
the elastic member is connected to the main body and the connecting plate, and is configured to drive the tension pulley through the connecting plate to abut against the transmission belt and to locate the connecting plate between the stop member and the stop portion for blocking; and the elastic member is further configured to drive the connecting plate away from a position between the stop member and the stop portion when the transmission belt breaks to bring the stop member into limit fit with the stop portion.

4. The conveying device of claim 3, wherein the tensioning assembly further comprises a mounting shaft, the connecting plate is rotatably connected to the main body through the mounting shaft, the tension pulley is located at one end of the connecting plate, the other end of the connecting plate is configured to be located between the stop member and the stop portion for blocking, and the mounting shaft is located between two ends of the connecting plate.

5. The conveying device of claim 1, wherein
the stop portion is provided with a stop structure, which is used for limit fit with the stop member when the transmission belt breaks.

6. The conveying device of claim 5, wherein
the number of stop structures is more than one, the stop structures are evenly distributed along a preset circumference, and a center of the preset circumference is located on an axis of the driven part.

7. The conveying device of claim 5, wherein the main body is connected to a mounting base, the stop member is a stop pin, the stop structure is a stop hole, and the mounting base is elastically connected to the stop pin to insert the stop pin into the stop hole under an elastic force.

8. The conveying device of any one of claims 1 to 7, wherein the transmission belt mechanism further comprises a driven pulley, and the stop portion is disposed between the driven pulley and the main body.

9. The conveying device of any one of claims 1 to 7, wherein the main body further comprises a lifting portion and a frame, the driven part is a lead screw, the lead screw is vertically disposed, the lifting portion is in thread fit with the lead screw, the frame is configured to limit rotation of the lifting portion, and the lifting portion is configured to support a carrier boat and drive the carrier boat to ascend and descend.

10. The conveying device of claim 7, wherein the mounting base is provided with a mounting hole, the mounting hole is provided therein with a mounting cylinder, the stop member is partially inserted into the mounting cylinder, and is in clearance fit with the mounting cylinder, and an elastic support is disposed between a bottom of the mounting cylinder and the stop member.

11. The conveying device of claim 10, wherein an end of the stop member away from the mounting cylinder is provided with a guide head, and a diameter of the guide head gradually decreases in a direction away from the mounting cylinder.

12. A vertical heat treatment apparatus, comprising an apparatus main body and the conveying device of any one of claims 1 to 11, and
the conveying device comprises the driven part and a lifting portion in driving engagement with the driven part, the driven part is configured to drive the lifting portion to ascend to transfer wafers into the apparatus main body or to descend to transfer the wafers out of the apparatus main body, the stop member is used for limit fit with the stop portion when the transmission belt breaks to limit rotation of the driven part, so as to prevent the lifting portion from falling.
